(19) Europäisches Patentamt
European Patent Office
Office européen des brevets

(11) Publication number: **0 341 028 A2**

# (12) EUROPEAN PATENT APPLICATION

(21) Application number: **89304417.2**

(22) Date of filing: **02.05.89**

(51) Int. Cl.[4]: **C 08 G 73/10**
G 03 C 1/70

(30) Priority: **02.05.88 JP 109538/88**

(43) Date of publication of application:
**08.11.89 Bulletin 89/45**

(84) Designated Contracting States:
**CH DE FR GB IT LI**

(71) Applicant: **Chisso Corporation**
**6-32, Nakanoshima 3-chome Kita-ku**
**Osaka-shi Osaka-fu (JP)**

(72) Inventor: **Maeda, Hirotoshi**
**10-2, Otsutomocho Kanazawa-ku**
**Yokohama-shi Kanagawa-ken (JP)**

**Kunimune, Kouichi**
**12-2, Ichihara**
**Ichihara-shi Chiba-ken (JP)**

(74) Representative: **Lamb, John Baxter et al**
**MARKS & CLERK 57/60 Lincoln's Inn Fields**
**London WC2A 3LS (GB)**

## (54) Process for the preparation of photosensitive polymers.

(57) A process for the preparation of a photosensitive poly(amide)imide precursor containing repeating units of the formulae:

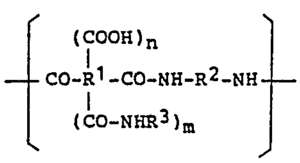

(IV)

(in which $R^1$ is a trivalent or tetravalent carbocyclic aromatic group or heterocyclic group; $R^2$ is an aliphatic group having at least 2 carbon atoms, an alicyclic group, an aromatic aliphatic group, a carbocyclic aromatic group, a heterocyclic group or a polysiloxane group; $R^3$ is a monovalent organic group having a photosensitive unsaturated group; m is 1 or 2; n is 0 or 1; and the sum of m and n is 1 or 2); which comprises reacting at a temperature of from 0 to 100°C, a poly(amide) isoimide containing repeating units of the formulae:

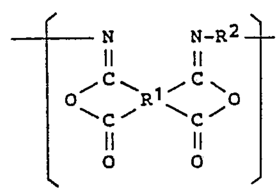

(I)

and/or

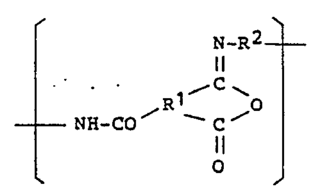

(II)

(in which $R^1$ and $R^2$ have the meanings defined above). with an amine of the formula:

$R^3 - NH_2$ (III)

(in which $R^3$ has the meaning defined above).

EP 0 341 028 A2

## Description

### Process for the Preparation of Photosensive Polymers

The present invention relates to a process for the preparation of photosensitive heat-resistant polymers. More particularly, the present invention relates to a process for the preparation of novel photosensitive poly(amide)imide precursors having good shelf stability and sensitivity.

As heat-resistant photosensitive materials, photosensitive polyimides are widely used as starting materials for insulating films of semi conductors and for passivation films. For example, in Japanese Patent Laid-open Publication No. 145794/1979, a process is suggested in which a compound containing a double bond and an amino group or its quaternary salt is mixed with polyamic acid. Furthermore, in Japanese Patent Laid-Open Publication Nos. 45746/1980 and 100143/1985, other processes are suggested in which an unsaturated expoxy compound or an isocyanate compound having a double bond is reacted with the carboxyl group of each polyamic acid. Japanese Patent Publication No.41422/1980 discloses a polymer in which an active functional group such as a double bond is introduced into the ester side chain of polyamic acid. In addition, Japanese Patent Laid-Open Publication No. 6029/1985 discloses a process fo synthesizing a polyimide using a diamine having a double bond, which has been previously synthesized.

The process described in Japanese Patent Laid-open Publication No.145794/1979 has the drawback that since a great deal of the compound containing the amino group or its quaternary salt is added to the unstable polyamic acid solution, the viscosity of the solution changes noticeably with time. The techniques in Japanese Patent Laid-open Publications Nos. 45746/1980 and 100143/1985 have the drawback that when the compound having the photosensitive unsaturated group is reacted with the carboxyl group of the polyamic acid, the viscosity of the solution changes owing to the partial decomposition of the polyamic acid etc. Furthermore, in Japanese Patent Publication Nos. 41422/1980 and 6029/1985, the process for the introduction of the photosensitive functional group is complicated and expensive.

An object of the present invention is to provide a process for the ready preparation of novel photosensitive poly(amide)imide precursors having good shelf stability and sensitivity, and containing less impurities.

According to the invention there is provided a process for the preparation of a photosensitive polymer containing repeating units of the formula

$$\left[\begin{array}{c} (COOH)_n \\ | \\ CO{-}R^1{-}CO{-}NH{-}R^2{-}NH \\ | \\ (CO{-}NHR^3)_m \end{array}\right] \qquad (IV)$$

(in which $R^1$ is a trivalent or tetravalent carbocyclic aromatic group or heterocyclic group; $R^2$ is an aliphatic group having at least 2 carbon atoms, an alicyclic group, an aromatic aliphatic group, a carbocyclic aromatic group, a heterocyclic group or a polysiloxane group; $R^3$ is a monovalent organic group having a photosensitive unsaturated group; m is 1 or 2; n is 0 or 1; and the sum of m and n is 1 or 2); which comprises reacting, at a temperature of from 0 to 100°C, a poly(amide) isoimide containing repeating units of the formulae:

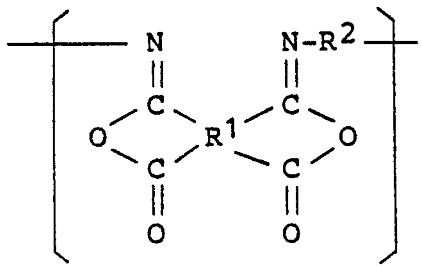

(I)

and/or

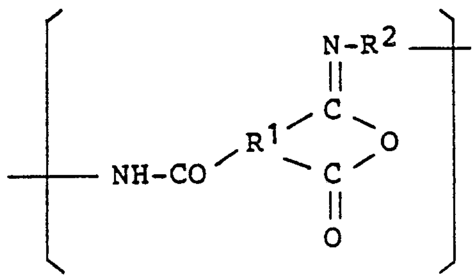

(II)

(in which $R^1$ and $R^2$ have the meanings defined above).
with an amine of the formula:
$R^3$ - $NH_2$ (III)
(in which $R^3$ has the meaning defined above).

A photosensitive polymer of the present invention having repeating units of formula (IV) is a photosensitive polyamide-imide precursor when m = 1 and n = 0, or a photosensitive polyimide precursor when n = 1 and n = 1 or when m = 2 and n = 0. Each of these photosensitive polymers can be prepared by reacting a poly(amide) isoimide containing either or both of repeating units of formulae (I) and (II) with an amine containing a photosensitive unsaturated group of formula (III) in the presence of a solvent at a temperature of 0 to 100°C.

The poly(amide)isoimide can be easily prepared by reacting either or both of a tetracarboxylic dianhydride and a tricarboxylic anhydride (which may mean their derivative in a certain case, and this is applied hereinafter) with a reaction product of a diamine in accordance with a process described on page 632 of "Proceedings of Second International Conferenece on Polyimides" (1985). The tetracarboxylic dianhydride, the tricarboxylic anhydride and the diamine can be represented by the following formulae (V), (VI) and (VII):

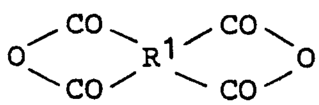

...... (V)

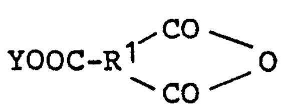

...... (VI)

wherein Y is H or Cl,
$NH_2$-$R^2$-$NH_2$ (VII)

These compounds will be described in detail.

When $R^1$ is a carbon cyclic aromatic group, this group $R^1$ preferably has at least one six-membered ring. In particular, $R^1$ is a polycyclic aromatic group having a monocyclic aromatic group, a condensed polycyclic aromatic group or several condensed rings or non-condensed rings (these rings are combined with each other directly or via a crosslinking group).

Suitable examples of the crosslinking group are as follows: -O-, $-CH_2-CH_2-$, $-CH_2-$, -CH = CH-, $-C_3F_6-$, -S-S-,

$-O-$, $-CH_2-CH_2-$, $-CH_2-$, $-CH=CH-$, $-C_3F_6-$, $-S-S-$,

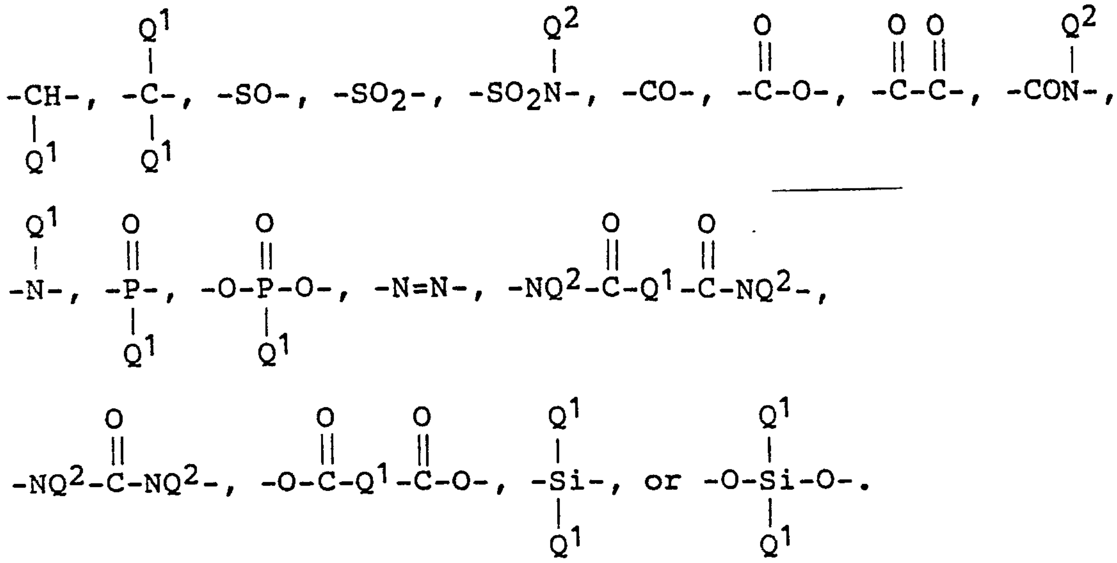

In the above-mentioned formulae, $Q^1$ is an alkyl group or an alkylene group which groups may be substituted by one or more halogen atoms (preferably fluorine atoms) and having 1 to 6 carbon atoms, preferably 1 to 4 carbon atoms, or $Q^1$ is a cycloalkyl group, an aryl group or an allylene group.

$Q^2$ is a hydrogen atom, a cycloalkyl group, an aryl group or an alkyl group which may be substituted by one or more halogen atoms and have 1 to 4 carbon atoms.

Furthermore, each of $Q^1$ and $Q^2$ may be a group comprising the above-mentioned groups which are combined with the interposition of two crosslinking groups, e.g., two $-SO_2-$ groups.

In the case that $R^1$ is a heterocyclic group, an example of the heterocyclic group is a heterocyclic aromatic group of a five-membered or a six-membered ring containing oxygen, nitrogen and/or sulfur, or a condensed cyclic group of the above-mentioned heterocyclic aromatic group and a benzene nucleus.

The carbon cyclic aromatic group or the heterocyclic group which $R^1$ represents may be substituted by, for example, one or more of a nitro group, an alkyl group having 1 to 4 carbon atoms, a trifluoromethyl group, a halogen atom (particularly a fluorine atom), a silyl group or a sulfamoyl group.

The group which $R^1$ represents may not be substituted or may be substituted by, for example, one or more of a halogen atom (e.g., fluorine, chlorine or bromine), or an alkyl group or an alkoxy group having 1 to 4 carbon atoms.

In the case that $R^2$ is a carbon cyclic aromatic group, a preferable example of the carbon cyclic aromatic group is a monocyclic aromatic group, a condensed polycyclic aromatic group or a non-condensed dicyclic aromatic group. In the case of this non-condensed dicyclic aromatic group, the aromatic rings are combined with each other via a crosslinking group. Examples of the crosslinking group are the same as recited in the description regarding $R^1$.

In the case that $R^2$ is a heterocyclic group, an example of the heterocyclic group is particularly a heterocyclic aromatic group of a five-membered or a six-membered ring containing oxygen, nitrogen and/or sulfur.

In the case that $R^2$ is an aliphatic group, an example of the aliphatic group is particularly an alkylene group having 2 to 12 carbon atoms, or another alkylene group in which a heteroatom such as oxygen, sulfur or nitrogen is present in the alkylene chain.

In the case that $R^2$ is an alicyclic group, an example of the alicyclic group is a cyclohexyl group or a dicyclohexylmethane group. Moreover, in the case that $R^2$ is an aromatic aliphatic group, an example of the aromatic aliphatic group is particularly a 1,3-, 1,4- or 2,4-bis-alkylene benzene group, a 4,4′-bis-alkylene-diphenyl group or a 4,4′-bis-alkylene-diphenyl ether group.

With regard to $R^1$, it is preferred that each $R_1$ is independently a non-substituted monocyclic aromatic group, a non-substituted condensed polycyclic aromatic group or a non-substituted non-condensed dicyclic aromatic group. In the case of this non-substituted non-condensed dicyclic aromatic group, the aromatic rings are combined with each other via a crosslinking group such as -O- or -CO-.

On the other hand, with regard to $R^2$, it is preferred that each $R^2$ is independently a monocyclic aromatic group or a non-condensed dicyclic aromatic group which groups may be substituted by one or more halogen atoms or one or more alkyl groups or alkoxy groups each having 1 to 4 carbon atoms, or a non-substituted monocyclic aromatic aliphatic group or a non-substituted aliphatic group having 2 to 10 carbon atoms.

In the case that $R^2$ is a polysiloxane group, this group can be represented by the formula (VIII):

$$-R^5-(\underset{R^6}{\overset{R^6}{\mid}}{Si}-O)_{\ell}-\underset{R^6}{\overset{R^6}{\mid}}{Si}-R^5- \quad \ldots\ldots \quad (VIII)$$

wherein $R^5$ is independently $-(CH_2)s-$,

$-(CH_2)_s-$ 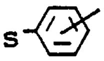 , $-(CH_2)_s-O-$ 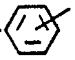 or - 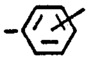

wherin s is an integer of 1 to 4, $R_6$ is independently an alkyl group having 1 to 6 carbon atoms, a phenyl group or an alkyl-substituted phenyl group having 7 to 12 carbon atoms, $\ell$ is a value of $1 \leqq \ell \leqq 100$.

Exemplary compounds of the tetracarboxylic dianhydride represented by the above-mentioned formula (V) are as follows:
Pyromellitic dianhydride,
3,3′,4,4′-benzophenone-tetracarboxylic dianhydride,
2,3,3′,4′-benzophenone-tetracarboxylic dianhydride,
2,2′,3,3′-benzophenone-tetracarboxylic dianhydride,
3,3′,4,4′-diphenyl-tetracarboxylic dianhydride,
2,2′,3,3′-diphenyl-tetracarboxylic dianhydride,
bis(2,3-dicarboxyphenyl)-methane dianhydride,
bis(3,4-dicarboxyphenyl)-methane dianhydride,
2,2-bis(2,3-dicarboxyphenyl)-propane dianhydride,
bis(3,4-dicarboxyphenyl)-ether dianhydride,
bis(3,4-dicarboxyphenyl)-sulfone dianhydride,
N,N-(3,4-dicarboxyphenyl)-N-methylamine dianhydride,
3,3′,4,4′-tetracarboxybenzoyloxybenzene dianhydride,
2,3,6,7-naphthalene-tetracarboxylic dianhydride,
1,2,5,6-naphthalene-tetracarboxylic dianhydride,
thiophene-2,3,4,5-tetracarboxylic dianhydride,
pyrazine-2,3,5,6-tetracarboxylic dianhydride,
pyridine-2,3,5,6-tetracarboxylic dianhydride,
2,3,3′,4′-biphenyltetracarboxylic dianhydride, and
2,2-bis(3,4-dicarboxyphenyl)hexafluoropropane dianhydride.

As the tricarboxylic anhydride represented by the formula (VI), trimellitic anhydride and trimellitic anyhdride chloride are particularly preferable.

As the diamines represented by the above-mentioned formula (VII), known compounds are used.

Exemplary compounds of the carbon cyclic aromatic diamines are particularly as follows:
o-, m- and p-Phenylenediamine, diaminotoluenes (e.g., 2,4-diaminotoluene), 1,4-diamino-2-methoxybenzene, 2,5-diaminoxylenes, 1,3-diamino-4-chlorobenzene, 1,4-diamino-2,5-dichlorobenzene, 1,4-diamino-2-bromobenzene, 1,3-diamino-4-isopropylbenzene, N,N′-diphenyl-1,4-phenylenediamine, 4,4′-diaminodiphenyl-2,2-propane, 4,4′-diaminodiphenylmethane, 2,2′-diaminostilbene, 4,4′-diaminostilbene, 4,4′-diamino diphenyl ether, 4,4′-diamino diphenyl thioether, 4,4′-diaminodiphenylsulfone, 3,3′-diaminodiphenylsulfone, 4,4′-diaminobenzoic phenyl ester, 2,2′-diaminobenzophenone, 4,4′-diaminobenzophenone, 4,4′-diaminobenzyl, 4-(4′-aminophenylcarbamoyl)-aniline, bis(4-aminophenyl)-phosphine oxide, bis(4-aminophenyl)-methyl-phosphine oxide, bis(3-aminophenyl)-methylsulfine oxide, bis(4-aminophenyl)phenylphosphine oxide, bis(4-aminophenyl)-cyclohexylphosphine oxide, N,N-bis(4-aminophenyl)-N-phenylamine, N,N-bis(4-aminophenyl)-N-methylamine, 4,4′-diaminodiphenyl urea, 1,8-diaminonaphthalene, 1,5-diaminonaphthalene, 1,5-diaminoanthraquinone, diaminofluoranthene, bis(4-aminophenyl)-diethylsilane, bis(4-aminophenyl)-dimethylsilane, bis(4-aminophenyl)-tetramethyldisiloxane, 3,4′-diaminodiphenyl ether, benzidine, 2,2′-dimethylbenzidine, 2,2-bis[4-(4-aminophenoxy)phenyl]propane, bis[4-(4-aminophenoxy)phenyl]sulfone, 4,4′-bis(4-aminophenoxy)biphenyl, 2,2-bis[4-(4-aminophenoxy)phenyl]hexaphloropropane, 1,4-bis(4-aminophenoxy)benzene and 1,3-bis(4-aminophenoxy)benzene.

Exemplary compounds of the heterocyclic diamines are as follows:
2,6-Diaminopyridine, 2,4-diaminopyridine, 2,4-diamino-s-triazine, 2,7-diamino-dibenzofuran, 2,7-diaminocarbazole, 3,7-diaminophenothiazine, 2,5-diamino-1,3,4-thiadiazole, 2,4-diamino-6-phenyl-s-triazine.

Furthermore, exemplary compounds of the aliphatic diamine are as follows:
Dimethyldiamine, trimethylenediamine, tetramethylenediamine, hexamethylenediamine, heptamethylenediamine, octamethylenediamine, nonamethylenediamine, decamethylenediamine, 2,2-dimethylpropyldiamine, 2,5-dimethylhexamethylenediamine, 2,5-dimethylheptamethylenediamine, 4,4-dimethylheptamethylenediamine, 3-methylheptamethylenediamine, 3-methoxyheptamethylenediamine, 5-methylnonamethylenediamine, 2,11-diaminododecane, 1,12-diaminooctadecane, 1,2-bis(3-aminopropoxy)-ethane, N,N′-dimethylethylenediamine, N,N′-diethyl-1,3-diaminopropane, N,N′-dimethyl-1,6-diaminohexane and a diamine rep-

resented by the formula $H_2N(CH_2)_3O(CH_2)_2O(CH_2)_3NH_2$.

Suitable exemplary compounds of the alicyclic diamine include 1,4-diaminocyclohexane and 4,4′-diamino-dicyclohexylmethane, and suitable exemplary compounds of the aromatic aliphatic diamine include 1,4-bis(2-methyl-4-aminopentyl)-benzene, 1,4-bis(1,1-dimethyl-5-aminopentyl)-benzene, 1,3-bis(aminomethyl)-benzene and 1,4-bis(aminomethyl)-benzene.

Moreover, exemplary compounds of the diaminopolysiloxane are as follows:

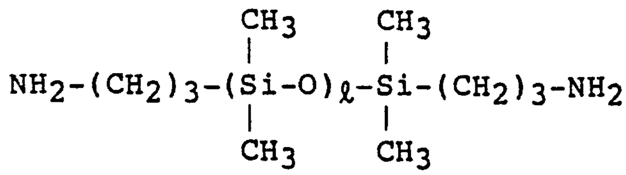

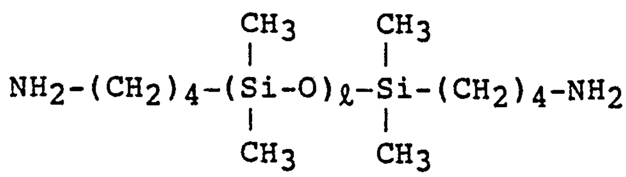

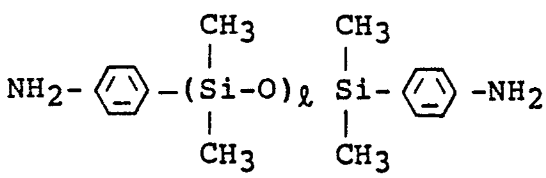

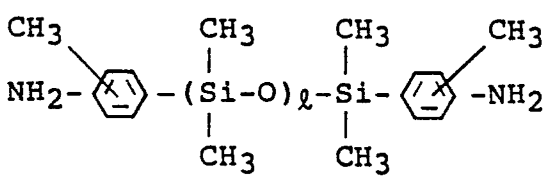

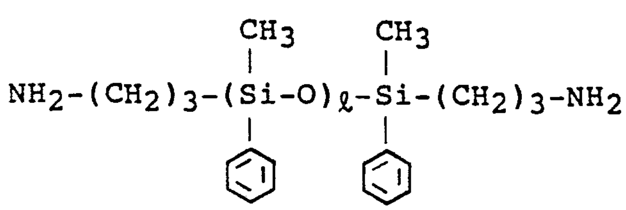

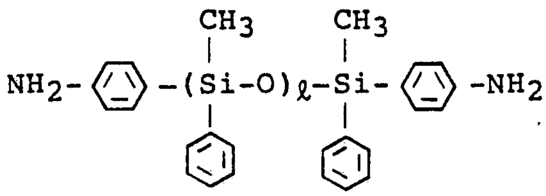

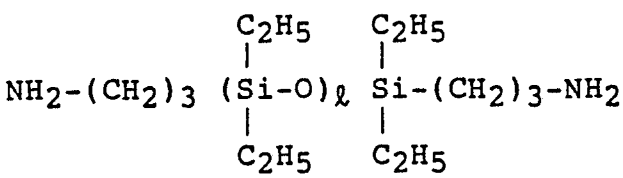

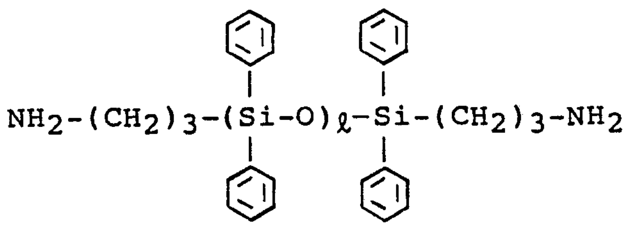

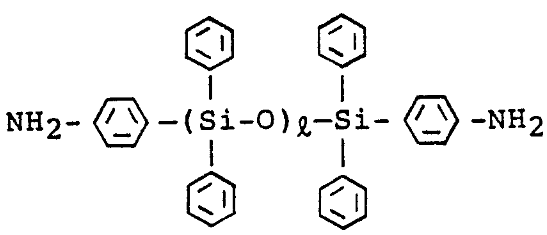

Reference will be made to the amine containing the photosensitive unsaturated group represented by the general formula (III).

Examples of $R^3$ are as follows:

$-(CH_2)_t-CH=CH_2$,

$-(CH_2)_t-O-\underset{\underset{O}{\|}}{C}-CH=CH_2$,

$-(CH_2)_t-O-\underset{\underset{O}{\|}}{C}-\underset{\underset{CH_3}{|}}{C}=\ H_2$,

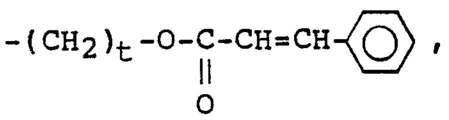

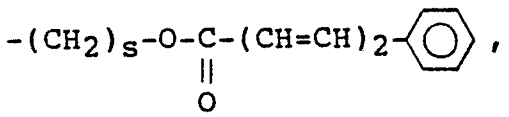

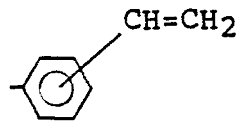

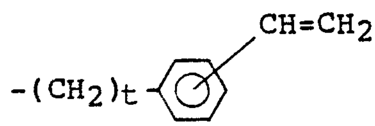

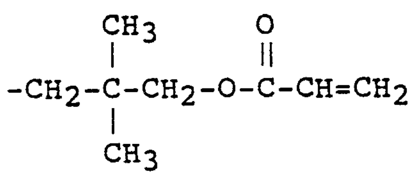

$-CO-CH=CH_2$, $-(CH_2)_t-NH-CO-CH=CH_2$ and $-CO-C(CH_3)=CH_2$
wherein t is a value of 1, 2 or 3.

Preferable examples of the solvent (hereinafter referred to as "reaction solvent" at times) for the preparation of the photosensitive polymer according to the process of the present invention are as follows:
N-Methyl-2-pyrrolidone, N,N-dimethylacetamide, N,N-dimethylformamide, dimethylsulfoxide, tetramethyl urea, pyridine, dimethylsulfone, hexamethylphosphoramide, methylformade, N-acetyl-2-pyrrolidone, ethylene glycol monomethyl ether, ethylene glycol monoethyl ether, ethylene glycol monobutyl ether, diethylene glycol monomethyl ether, diethylene glycol dimethyl ether, cyclopentanone, cyclohexanone, cresol, γ-butyrolactone, N,N-diethylacetamide, N,N-diethylformamide, N,N-dimethylmethoxyacetamide, tetrahydrofuran, N-acetyl-2-pyrrolidone, N-methyl-ε-caprolactam and tetrahydrothiophene dioxide (sulpholane).

Furthermore, the reaction for the preparation of the photosensitive polymer can be performed in a mixed solvent obtained by mixing two or more kinds of the above-mentioned organic solvents. In addition, the above-mentioned organic solvent, when used, can be diluted with, for example, another non-protonic (neutral) organic solvent such as an aromatic, alicyclic or aliphatic hydrocarbon or their chlorinated derivative (e.g, benzene, toluene, xylenes, cyclohexane, pentane, hexane, petroleum ether or methylene chloride) or dioxane.

A poly(amide)amic acid can be synthesized from the above-mentioned acid anhydride and diamine in accordance with a known process in the presence of the aforesaid solvent.

In this case, an aminosilane represented by the following formula (IX) can be introduced into the terminal of the polymer with the intention of improving adhesive properties to the substrate.

$NH_2-R^7-SiR^8_{3-k}X_k$ (IX)

wherein $R^7$ is $-(CH_2)_s$,

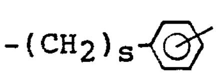 , 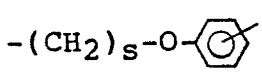

or

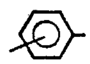

wherein s is an integer of 1 to 4, $R^8$ is independently an alkyl group having 1 to 6 carbon atoms, a phenyl group or an alkyl-substituted phenyl group having 7 to 12 carbon atoms, X is independently a hydrolytic alkoxy group, acetoxy group or a halogen, and k is a value of $1 \leqq k \leqq 3$.

Exemplary compounds of the aminosilane represented by the formula (IX) are as follows: Aminomethyl-di-n-propoxy-methylsilane, (β-aminoethyl)-di-n-propoxy-methylsilane, (β-aminoethyl)-diethoxy-phenylsilane, (β-aminoethyl)-tri-n-propoxysilane, (β-aminoethyl)-dimethoxy-methylsilane, (γ-aminopropyl)-di-n-propoxy-methylsilane, (γ-aminopropyl)-di-n-butoxy-methylsilane, (γ-aminopropyl)-trimethoxysilane, (γ-aminopropyl)-triethoxysilane, (γ-aminopropyl)-di-n-pentoxy-phenylsilane, (γ-aminopropyl)-methoxy-n-propoxy-methylsilane,(δ-aminobutyl)-dimethoxymethylsilane, (3-aminophenyl)-di-n-propoxy-methylsilane, (4-aminophenyl)-tri-n-propoxysilane, [β-(4-aminophenyl)-ethyl]-diethoxy-methylsialne, [β-(3-aminophenyl)-ethyl]-di-n-propoxy-phenylsilane, [γ-(4-aminophenyl)-propyl]-di-n-propoxy-methylsilane, [γ-(4-aminophenoxy)-propyl]-di-n-propoxy-methylsilane, [γ-(3-aminophenoxy)-propyl]-di-n-butoxy-methylsilane, (γ-aminopropyl)-methyl-dimethoxysilane, (γ-aminopropyl)-methyl-diethoxysilane, (γ-aminopropyl)-ethyl-di-n-propoxysilane, 4-aminophenyl-trimethoxysilane, 3-aminophenyltrimethoxysilane, 4-aminophenyl-methyl-dimethoxysilane, 3-aminophenyl-di-methyl-methoxysilane and 4-aminophenyl-tri-ethoxysilane.

In addition, with the intention of controlling the molecular weight of the poly(amide)amic acid, a monofunctional acid anhydride or an amine is used at the time of the reaction. Exemplary compounds of the monofunctional acid anhydride or the amine include phthalic anhydride, maleic anhydride, aniline and monoallylamine.

The thus synthesized polyamic acid can be easily converted into a polyisoimide by, for example, a dehydrating agent such as N,N′-dicyclohexylcarbodiimide or triphloroacetic anhydride in accordance with the process described in the above-mentioned "Proceeding of Second International Conference on Polyimides". In this case, an imide group is formed sometimes, depending upon reaction conditions.

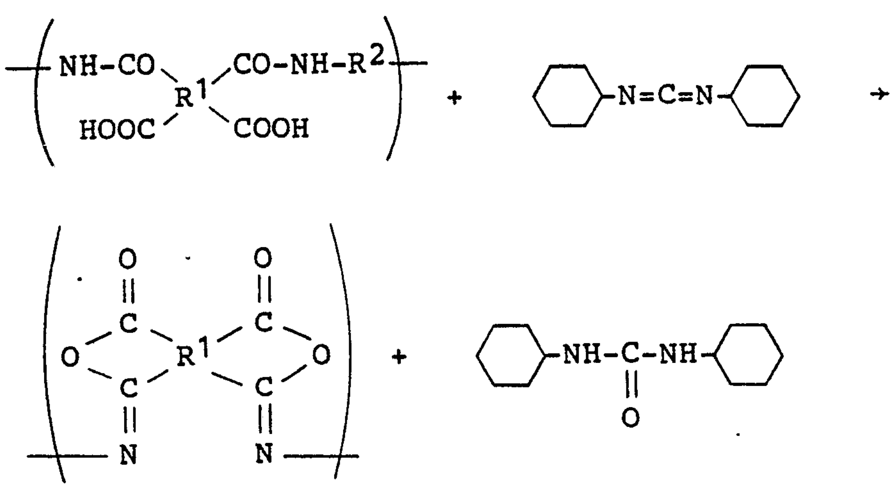

The reaction of N,N′-dicyclohexylcabodiimide as the dehydrating agent with the polyamic acid is shown hereinbefore, but it is not always necessary that all of amic acid is converted into the isoimide. However, when the ratio of the isoimide in the polymer decreases, the ratio of the photosensitive group to be added also decreases, with the result that the sensitivity of the polymer deteriorates. In consequence, it is preferable that the conversion of amic acid into the isoimide is accomplished as much as possible.

Next, at least one member of the photosensitive unsaturated group-containing amines represented by the formula (III) is added to this poly(amide)isoimide, and reaction is performed therebetween in the presence of the reaction solvent. It is preferred that the amine to be added is nearly equimolar with the isoimide, though it may be more than or less than the quimolar level. Reaction temperature is in the range of 0 to 100°C, preferably about 10 to 30°C. Reaction time is in the range of 0.2 to 30 hours, preferably about 1 to 10 hours.

In this way, the photosensitive polymer of the present invention which contains the repeating unit represented by the general formula (IV) can be obtained. The inherent viscosity of this plolymer is preferably in the range of 0.1 to 5 dl/g from the viewpoint of film formation properties. This inherent viscosity (ηinh) can be represented by the formula

$\eta inh = (\ell n\eta/\eta_o)/C$

wherein η is a viscosity of the polymer which is measured at a temperature of 30±0.01°C at a concentration of 0.5 g/dl in a solvent by the use of Ubbelohde's viscometer, $\eta_o$ is a viscosity of the same solvent at the same temperature by the same viscometer, and C is a concentration of the polymer, i.e., 0.5 g/dl.

The photosensitive polymer of the present invention can be stored in the state of a solution, or it can be also

stored likewise in the solid state of powder or masses which are prepared by adding the polymer solution to a great deal of a non-solvent so as to deposit the polymer, and then filtering and drying the deposited polymer.

The photosensitive polymer synthesized by the preparation process of the present invention is composed of the above-mentioned components (a), (b), (c) and (d).

(a) Photosensitive Polymer:

The photosensitive polymer (a) contains the repeating unit represented by the general formula (IV), but this repeating unit need not occupy 100% of all the repeating units. However, in practice, it is preferred that the repeating unit of the general formula (IV) is present in a ratio of 30 mole% or more of all the repeating units. The repeating units other than the repeating unit represented by the general formula (IV) are not particularly limited, but they practically comprise one or more kinds of the following repeating units.

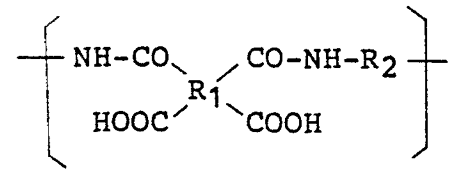

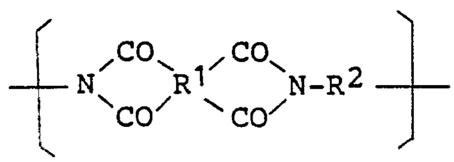

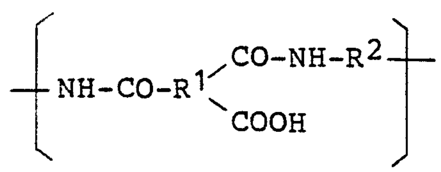

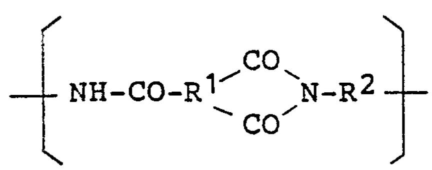

The concentration of the photosensitive polymer in the photosensitive polymer composition is in the range of 2 to 50% by weight, preferably 10 to 30% by weight.

(b) Photopolymerization Initiator or Sensitizer:

Exemplary compounds of the photopolymerization initiator or sensitizer (b) are as follows:
Benzoin, benzoin ether, benzophenone, p,p′-dimethyl benzophenone, 4,4′-bis(diethylamino benzophenone), Michler's ketone, 2-nitrofluorene, 5-nitroacenaphthene, 4-nitro-1-naphthylamine, anthrone, 1,9-benzanthrone, dibenzal acetone, anthraquinone, 2-methylanthraquinone, 1-nitropyrene, 1,8-dinitropyrene, pyrene-1,6-quinone, cyanoacridine, benzoquinone, 1,2-naphthoquinone, 1,4-naphthoquinone and 1,2-benzanthraquinone.

These compounds may be used singly or in combination.

The amount of the photopolymerization initiator or sensitizer is in the range of 0 to 20% by weight, preferably 0 to 10% by weight based on the photosensitive polymer.

(c) Diazide Compound:

Examples of the diazide compound (c) include 2,6-di(p-azidobenzal)-4-methylcyclohexanone, 2,6-di(p-azidobenzal)-cyclohexanone, 4,4′-diazidochalcone, 4,4′-diazidobenzal acetone, 4,4′-diazidostilbene, 4,4′-diazido benzophenone, 4,4′-diazidodiphenylmethane and 4,4′-diazidodiphenylamine.

These diazide compounds may be used singly or in combination.

The amount of the diazide compound is in the range of 0 to 50% by weight, preferably 0 to 20% by weight based on the photosensitive polymer.

(d) Compound having Carbon-Carbon Double Bond:

Examples of the compound (d) having the carbon-carbon double bond are as follows:
Butyl acrylate, cyclohexyl acrylate, dimethylaminoethyl methacrylate, benzyl acrylate, Carbitol acrylate,

2-ethylhexyl acrylate, 2-ethylhexyl methacrylate, lauryl methacrylate, 2-hydroxyethyl acrylate, 2-hydroxyethyl methacrylate, 2-hydroxypropyl acrylate, 2-hydroxypropyl methacylate, glycidyl methacrylate, N-methylolacrylamide, N-diacetoneacrylamide, N,N′-methylenebisacrylamide, N-vinylpyrrolidone, ethylene glycol diacrylate, diethylene glycol diacrylate, triethylene glycol diacrylate, butylene glycol diacrylate, butylene glycol dimethacrylate, neopentyl glycol diacrylate, neopentyl glycol dimethacrylate, 1,4-butanediol diacrylate, 1,6-hexanediol diacrylate, 1,6-hexanediol dimethacrylate, pentaerythritol diacrylate, pentaerythritol triacrylate, trimethylolpropane triacrylate and trimethylolpropane trimethacrylate.

These compounds may be used singly or in combination.

The amount of the compound (d) having the carbon-carbon double bond is in the range of 0 to 10% by weight, preferably 0 to 5% by weight based on the photosensitive polymer.

In the present invention, secondary materials such as a crosslinking agent, a dye and a pigment can be additionally used. The crosslinking agent is, for example, a known polyvalent thiol such as pentaerythritol tetra(3-mercapto propionate) or pentaerythritol tetra(mercapto acetate). They are used in an amount of 10% by weight or less based on the photosensitive polymer.

A photosensitive polymer composition can be obtained by dissolving the compounds (a), (b), (c) and (d) in the abovementioned reaction solvent in the aforesaid ratio.

Next, reference will be made to a process for forming a patterned poly(amide)imide film by the use of the polymer composition of the present invention.

The polymer composition prepared by the process of the present invention is applied onto a substrate such as a silicone wafer, a metallic plate, a plastic plate or a glass plate in accordance with a known means such as spin coating, immersion or spray printing. The coating film on the substrate is then prebaked at a temperature of 30 to 150°C for a period of several minutes to several tens minutes by the use of a heating means such as an electric furnace or a hot plate so as to remove most of the solvent therefrom. Afterward, a negative mask is put on the coating film, and the latter is then irradiated with chemical rays through the mask. Examples of the chemical rays include X-rays, electron beams, ultraviolet rays and visible light, and above all, the ultraviolet rays are particularly preferable. Then, the unexposed portions of the film are dissolved in and removed by a developing solution therefrom, thereby obtaining a relief pattern. The developing solution can be selected from the above-mentioned reaction solvents, and a mixture of the solvent and a lower alcohol such as methanol, ethanol or propanol which is the non-solvent for the photosensitive polymer of the present invention may be also used as the developing solution. If desired, the relief pattern is rinsed with the above-mentioned non-solvent, and if desired, it is further dried at a temperature of 150°C or less, whereby the relief pattern can be stabilized. Moreover, the coating film can be peeled from the substrate at an optional step after the prebaking process, and it can be used as a single film. The polymer of the relief pattern formed by the development is in the form of a precursor, and therefore it is then heated at a temperature of 200 to 500°C, preferably 300 to 400°C for a period of several tens minutes to several hours, so that the patterned poly(amide)imide film is formed. In this case, chemical reaction makes progess as follows:

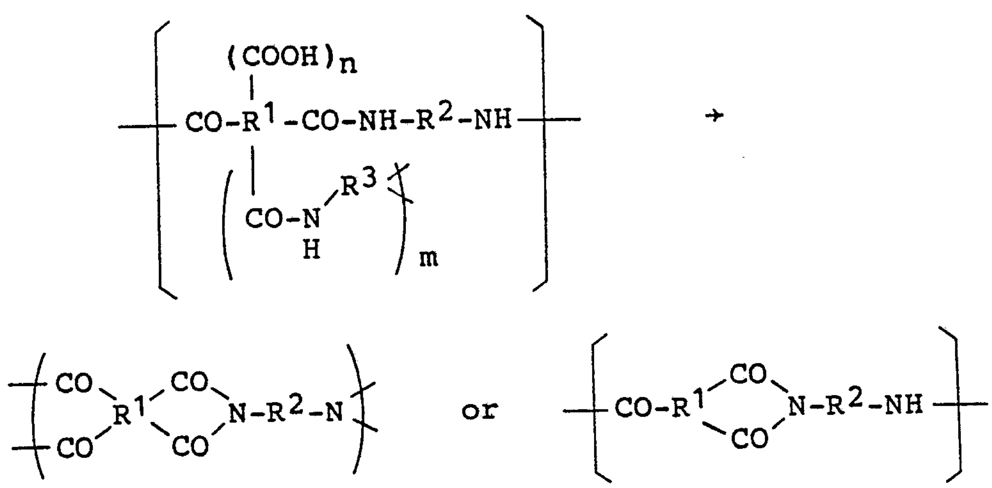

or

As is apparent from the above chemical reaction, the photosensitive component is thermally decomposed to form the poly(amide)imide.

As is apparent from the foregoing, the patterned poly(amide)imide film having heat resistance can be obtained from the photosensitive polymer prepared by the process of the present invention.

According to the process of the present invention, the photosensitive group can be easily introduced into the poly(amide)imide precursor and the thus obtained photosensitive polymer to which suitable additives are added, if necessary, has practically sufficient sensitivity and is also excellent in shelf stability.

The photosensitive polymer synthesized by the process of the present invention is applicable as electronic materials, particularly as materials for passivation films of semiconductors, print circuits and the like.

## EXAMPLES

The present invention will be described in detail in reference to examples, but the scope of the present invention should not be limited by these examples.

In the first place, preparation examples of poly(amide)isoimides which will be used in the respective examples will be described as reference examples.

Reference Example 1

A 1-liter flask equipped with a stirrer, a dropping funnel, a thermometer, a condenser and a nitrogen-replacing device was fixed to a thermostatic chamber. In this flask were placed 500 g of dehydrated and purified N-methyl-2-pyrrolidone (hereinafter referred to simply as NMP), 60.39 g (0.302 mol) of 4,4′-diaminodiphenyl ether (hereinafter referred to simply as DDE) and 2.46 g (0.0431 mol) of monoallylamine, and the solution was stirred to dissolve the components in NMP. Afterward, to the solution was added 104.13 g (0.323 mol) of 3,3′,4,4′-benzophenonetetracarboxylic dianhydride (hereinafter referred to simply as BTDA), and reaction was performed at a temperature of 20 to 30° C for 10 hours, thereby obtaining a polyamic acid, to a terminal of which monoallyamine was added. To this solution was further added 133.27 g (0.646 mol) of N,N′-dicyclohexylcarbodiimide (hereinafter referred to simply as DCC), and the reaction was further performed at this temperature for 10 hours, whereby white N,N′-dicyclohexyl urea was deposited. The thus deposited white precipitate was removed therefrom by filtration, and the resulting filtrate was added dropwise to a great deal of acetone, so that a polyisoimide was deposited. This product was collected by filtration and dried overnight at 50° C under reduced pressure, thereby isolating the polyisoimide.

Reference Example 2

By the use of the same procedure and devices as in Reference Example 1, 64.89 g (0.150 mol) of bis[4-(4-aminophenoxy)phenyl]sulfone was dissolved in 500 g of N,N′-dimethylacetamide, and 53.71 g (0.167 mol) of BTDA was added thereto and reaction was then performed at 15 to 20° C for 8 hours. Afterward, 6.40 g (0.0300 mol) of 4-aminophenyltrimethoxysilane was added thereto, and the reaction was further carried out for 3 hours, so that a polyamic acid, to a terminal of which silane was added, was obtained. To this solution was added 70 g (0.339 mol) of DCC, and the reaction was performed at a temperature of 30 to 40° C for 10 hours, so that white N,N′-dicyclohexyl urea was deposited. The thus deposited white precipitate was then removed therefrom by filtration, and the resulting filtrate was treated in the same manner as in Reference Example 1, thereby isolating a polyisoimide.

Reference Example 3

By the use of the same procedure and devices as in Reference Example 1, 83.82 g (0.388 mol) of 4,4′-diaminodiphenyl sulfide was dissolved in 500 g of NMP, and 67.61 g (0.310 mol) of pyromellitic dianhydride was added thereto and reaction was then performed at 15 to 20° C for 5 hours. Afterward, 15.20 g (0.155 mol) of maleic anhydride was added thereto, and the reaction was further carried out for 5 hours, so that a polyamic acid, to a terminal of which maleic anhydride was added, was obtained. To this solution was added 123.78 g (0.600 mol) of DCC, and the reaction was performed at a temperature of 30 to 40° C for 10 hours, so that white N,N′-dicyclohexyl urea was deposited. The thus deposited white precipitate was then removed therefrom by filtration, and the resulting filtrate was treated in the same manner as in Reference Example 1, thereby isolating a polyisoimide in which a part of the polyamic acid was converted into an isoimide.

Reference Example 4

By the use of the same procedure and devices as in Reference Example 1, 63.79 g (0.319 mol) of DDE was dissolved in 500 g of NMP, and 61.21 g (0.319 mol) of trimellitic anhydride was added thereto and reaction was then performed at 20 to 30° C for 5 hours in order to form an addition product. Afterward, 131.62 g (0.638 mol) of DCC was further added thereto, and the reaction was further carried out for 20 hours, so that the conversion of amic acid into an isoimide and the condensation of the terminal amino group and a carboxyl group were simultaneously achieved to obtain a solution containing a polyamideisoimide. Deposited N,N′-dicyclohexyl urea was then removed from this solution by filtration, and the resulting filtrate was treated in the same manner as in Reference Example 1, thereby isolating a polyamideisoimide.

Reference Example 5

By the use of the same procedure and devices as in Reference Example 1, 33.38 g (0.0813 mol) of 2,2-bis[4-(4-aminophenoxy)phenyl]propane and 39.23 g (0.0813 mol) of 2,2-bis[4-(4-aminophenoxy)phenyl]hexaphloropropane were dissolved in 500 g of NMP, and 52.40 g (0.163 mol) of BTDA was further added thereto and reaction was then performed at 10 to 15° C for 10 hours to form a polyamic acid. Afterward, 67.25 g (0.326 mol) of DCC was added to this polyamic acid solution, and the reaction was further carried out at this temperature for 15 hours, so that white N,N′-dicyclohexyl urea was deposited. This white precipitate was removed from the solution by filtration, and the resulting filtrate was then treated in the same manner as in Reference Example 1, thereby isolating a polyisoimide.

Reference Example 6

By the use of the same procedure and devices as in Reference Example 1, 53.64 g (0.184 mol) of 1,3-bis(4-aminophenoxy)benzene and 2.40 g (0.00966 mol) of 1,3-bis(3-aminopropyl)tetramethyldisiloxane were dissolved in 500 g of NMP, and 69.15 g (0.193 mol) of diphenylsulfone-3,3′,4,4′-tetracarboxylic dianhydride was further added thereto and reaction was then performed at 20 to 30° C for 10 hours in order to form a polyamic acid. Afterward, 79.63 g (0.386 mol) of DCC was added to this polyamic acid solution, and the reaction was further carried out at this temperature for 20 hours, so that white N,N′-dicyclohexyl urea was deposited. This white precipitate was removed from the solution by filtration, and the resulting filtrate was then treated in the same manner as in Reference Example 1, thereby isolating a polyisoimide.

Example 1

A 200-milliliter flask equipped with a stirrer, a dropping funnel, a thermometer, a condenser and a nitrogen-replacing device was fixed to a thermostatic chamber. In this flask were placed 50 g of dehydrated and purified NMP and 50 g or γ-butyrolactone, and 20 g of the polyisoimide synthesized in Reference Example 1, and the solution was stirred to dissolve the component in NMP. To the solution was further added 4.81 g (0.0843 mol) of allylamine, and reaction was performed at a temperature of 40 to 50° C for 5 hours. The resulting reaction solution was added dropwise to a great deal of acetone, so that a photosensitive polymer was deposited. The thus deposited precipitate was collected by filtration and was then dried overnight at 50° C under reduced pressure, thereby isolating the polymer.

Example 2

By the use of the same procedure and devices in Example 1, 20 g of the polyisoimide synthesized in Reference Example 2 was added to 100 g of NMP, and the solution was then stirred to dissolve the polyisoimide therein. To this solution was added 3.33 g (0.0583 mol) of allylamine, and reaction was then performed at a temperature of 20 to 30° C for 12 hours. Afterward, the reaction solution was treated in the same manner as in Example 1, thereby isolating a photosensitive polymer.

Example 3

By the use of the same procedure and devices in Example 1, 20 g of the polyisoimide synthesized in Reference Example 3 was added to 100 g of NMP, and the solution was then stirred to dissolve the polyisoimide therein. To this solution was further added 4.47 g (0.0782 mol) of allylamine, and reaction was then performed at a temperature of 15 to 20° C for 20 hours. Afterward, the reaction solution was treated in the same manner as in Example 1, thereby isolating a photosensitive polymer.

Example 4

By the use of the same procedure and devices in Example 1, 20 g of the polyisoimide synthesized in Reference Example 4 was added to 100 g of NMP, and the solution was then stirred to dissolve the polyisoimide therein. To this solution was further added 3.20 g (0.0561 mol) of allylamine, and reaction was then performed at a temperature of 10 to 15° C for 5 hours and further at 60° C for 2 hours. Afterward, the reaction solution was treated in the same manner as in Example 1, thereby isolating a photosensitive polymer.

Example 5

By the use of the same procedure and devices in Example 1, 20 g of the polyisoimide synthesized in Reference Example 5 was added to 100 g of NMP, and the solution was then stirred to dissolve the polyisoimide therein. To this solution was further added 3.27 g (0.0573 mol) of allylamine, and reaction was then performed at a temperature of 30 to 40° C for 8 hours. Afterward, the reaction solution was treated in the same manner as in Example 1, thereby isolating a photosensitive polymer.

Example 6

By the use of the same procedure and devices in Example 1, 20 g of the polyisoimide synthesized in Reference Example 6 was added to 100 g of NMP, and the solution was then stirred to dissolve the polyisoimide therein. To this solution was further added 3.88 g (0.0680 mol) of diallylamine, and reaction was then performed at a temperature of 30 to 40° C for 10 hours. Afterward, the reaction solution was treated in the same manner as in Example 1, thereby isolating a photosensitive polymer.

Use Tests

In 25.5 g of NMP was dissolved 4.5 g of each of the photosensitive polymers of the present invention synthesized in Examples 1 to 6, and to the solution were further added a photopolymerization initiator or a sensitizer, a diazide compound and/or a compound having a carbon-carbon double bond so as to prepare a photosensitive polymer composition.

Next, this composition was applied onto a silicone wafer by spin coating, and was then prebaked at 70° C for 40 minutes in order to form a uniform coating film thereon. Afterward, the coating film was irradiated with an ultra-high pressure mercury vapor lamp (20mW/cm$^2$), irradiation time being varied. The irradiated film was then immersed in a mixed solution of 4 volumes of NMP and 1 volume of ethyl alcohol to develop the film, and the

developed coating film was then rinsed in ethyl alcohol, followed by drying, thereby obtaining a sharp relief pattern. Sensitivity was defined as an exposure required until a ratio of a remaining film thickness to an application film thickness became 0.5. The thus obtained relief pattern was then calcined at 200° C for 30 minutes and further at 400° C for 30 minutes in an electric furnace, but at this time, the pattern did not break. According to infrared absorption spectrum, it was confirmed that after the calcination, all the photosensitive polymers were converted into poly(amide)imide. Furthermore, in order to inspect the stability with time of these photosensitive polymers, the rotation viscosities of the photosensitive polymer compositions were measured immediately after the preparation and after they were allowed to stand at room temperature for 1 month, in order to examine the change in the rotation viscosities with time. Here, the rotation viscosity referred to above is a viscosity measured at a temperature of 25° C by the use of an E-type viscometer (made by Tokyo Keiki Co., Ltd.; trade mark VISCONIC EMD). The measured rotation viscosities of the photosensitive compositions in the respective examples are set forth in detail in Table 1.

Comparative Synthesis Example 1

By the use of the same procedure and devices as in Example 1, a polyamic acid solution having an inherent viscosity of 1.1 dl/g was synthesized from 100 g of NMP, 12.34 g (0.0383 mol) of BTDA and 7.66 g (0.0383 mol) of DDE. To this solution was added 14.19 g (0.0766 mol) of dimethylaminoethyl methacrylate in order to prepare a photosensitive polymer solution. Afterward, 30 g of this solution was sampled, and additives shown in Table 1 were added to the sampled solution, thereby obtaining a photosensive polymer. Next, a photosensitive test was made and the stability with time of the photosensive polymer was measured in the same manner as in the above-mentioned Use Tests. The results are set forth in Table 1.

Table 1

| | Photosensitive Polymer | Initiator or Sensitizer | Diazide Compound |
|---|---|---|---|
| Use Test Ex. 1 | polymer in Example 1 | Michler's ketone 0.45 g | - |
| Use Test Ex. 2 | " | Michler's ketone 0.45 g | A-1*1) 0.45 g |
| Use Test Ex. 3 | polymer in Example 2 | Benzoin isopropyl ether 0.45 g | A-1 0.3 g |
| Use Test Ex. 4 | polymer in Example 3 | 2-nitrofluorene 0.3 g | A-1 0.5 g |
| Use Test Ex. 5 | polymer in Example 4 | 5-nitroacenaphthene 0.5 g | A-1 0.5 g |
| Use Test Ex. 6 | polymer in Example 5 | 1-nitropyrene 0.2 g | A-1 0.3 g |
| Use Test Ex. 7 | polymer in Example 6 | 5-nitroacenaphthene 0.3 g | A-2*3) 0.2 g |
| Comp. Use Test Ex. 1 | polymer in Comp. Synthesis Ex. 1 | Michler's ketone 0.45 g | - |

*1) A-1: 2,6-Di(p-azidobenzal)-4-methylcyclohexanone
*3) A-2: 2,6-Di(p-azidobenzal)cyclohexanone.

Table 1 (Continued)

| | Compound Having Carbon-Carbon Double Bond | Sensitivity (film thickness) | Rotation Viscosity (cps) (after 1 month)/ (just after preparation) |
|---|---|---|---|
| Use Test Ex. 1 | - | 2.100 $mJ/cm^2$ (2.8 μm) | 350/380 |
| Use Test Ex. 2 | M-1*2) 0.3 g | 80 $mJ/cm^2$ (4.1 μm) | 1130/1210 |
| Use Test Ex. 3 | - | 110 $mJ/cm^2$ (2.8 μm) | 350/370 |
| Use Test Ex. 4 | - | 75 $mJ/cm^2$ (1.6 μm) | 255/270 |
| Use Test Ex. 5 | M-2*4) 0.3 g | 90 $mJ/cm^2$ (1.5 μm) | 240/260 |
| Use Test Ex. 6 | M-1 0.2 g | 100 $mJ/cm^2$ (4.9 μm) | 2130/2390 |
| Use Test Ex. 7 | - | 80 $mJ/cm^2$ (3.5 μm) | 810/860 |
| Comp. Use Test Ex. 1 | - | 4,600 $mJ/cm^2$ (4.2 μm) | 420/1220 |

*2) M-1: Trimethylpropane trimethacrylate

*4) M-2: Pentaerythritol trimethacrylate

## Claims

1. A process for the preparation of a photosensitive polymer containing repeating units of the formula

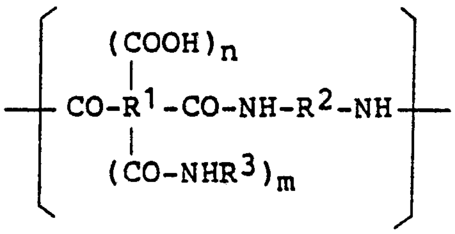

(IV)

(in which $R^1$ is a trivalent or tetravalent carbocyclic aromatic group or heterocyclic group; $R^2$ is an aliphatic group having at least 2 carbon atoms, an alicyclic group, an aromatic aliphatic group, a carbocyclic aromatic group, a heterocyclic group or a polysiloxane group; $R^3$ is a monovalent organic group having a photosensitive unsaturated group; m is 1 or 2; n is 0 or 1; and the sum of m and n is 1 or 2); which comprises reacting, at a temperature of from 0 to 100°C, a poly(amide) isoimide containing repeating units of the formulae:

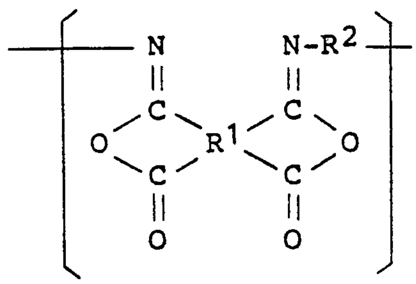

(I)

and/or

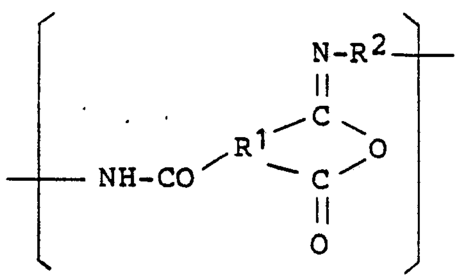

(II)

(in which $R^1$ and $R^2$ have the meanings defined above).
with an amine of the formula:
$R^3 - NH_2$ (III)
(in which $R^3$ has the meaning defined above).

2. A process according to claim 1 in which the amine is one of the formulae:

$NH_2-(CH_2)t-CH=CH_2$

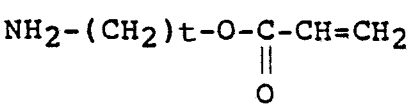

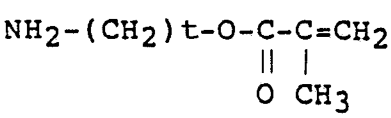

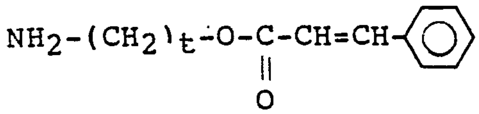

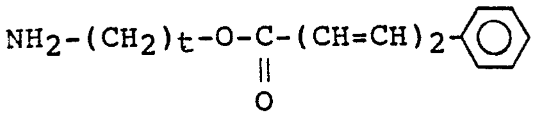

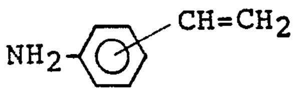

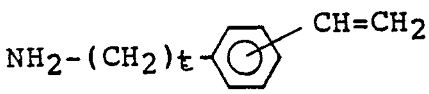

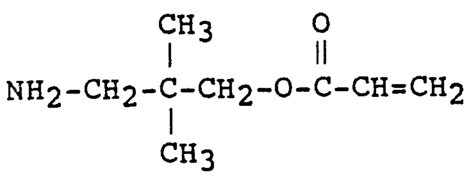

$NH_2-CO-CH=CH_2$

$NH_2-(CH_2)_t-NH-CO-CH=CH_2$ and/cr